# EUROPÄISCHE PATENTSCHRIFT

(11) **EP 1 587 152 B1**
(45) Veröffentlichungstag und Bekanntmachung des Hinweises auf die Patenterteilung: **10.01.2007**
(21) Anmeldenummer: 05101621.0
(22) Anmeldetag: 31.03.2005
(51) Int. Cl.: H01L 41/053

(54) **Vorrichtung mit piezoelektrischem Aktor**
Device with piezoelectric actuator
Dispositif avec actionneur piézoélectrique

(30) Priorität: 15.04.2004 DE 102004018224
(43) Veröffentlichungstag der Anmeldung: 19.10.2005
(73) Patentinhaber: ROBERT BOSCH GMBH, 70442 Stuttgart (DE)
(72) Erfinder: Wolff, Guenter, 71701, Schwieberdingen (DE); Doebler, Ulrich, 71686, Remseck (DE)

(56) Entgegenhaltungen:
- EP-A- 1 167 747
- DE-A1- 10 147 666
- DE-A1- 19 715 487
- US-B1- 6 316 864

## Beschreibung

### Stand der Technik

Die Erfindung geht aus von einer Vorrichtung mit einem piezoelektrischen Aktor nach der Gattung des Hauptanspruchs.

Es ist schon eine Vorrichtung aus der DE 197 15 487 C2 bekannt mit einem Piezoaktor, der eine erste elektrische Leitung, die mit einem ersten Steckerkontakt elektrisch leitend verbunden ist, und eine zweite elektrische Leitung, die mit einem zweiten Steckerkontakt elektrisch leitend verbunden ist, aufweist. Auf den Piezoaktor ist eine Kontaktplatte aufgesteckt, wobei die erste elektrische Leitung und die zweite elektrische Leitung durch jeweils ein durchgehendes Kontaktloch der Kontaktplatte ragen. Im Innern der Kontaktplatte sind zwei elektrische Verbindungsleitungen vorgesehen, die von den Kontaktlöchern ausgehend zu den Steckerkontakten verlaufen und die erste elektrische Leitung und die zweite elektrische Leitung des Piezoaktors mit jeweils einem der Steckerkontakte verbindet.
Nachteilig ist, dass die Vorrichtung vergleichsweise aufwendig und teuer ist.

### Vorteile der Erfindung

Die erfindungsgemäße Vorrichtung mit den kennzeichnenden Merkmalen des Hauptanspruchs hat demgegenüber den Vorteil, dass auf einfache Art und Weise eine Verbesserung dahingehend erzielt wird, dass die Herstellungskosten der Vorrichtung verringert werden, indem eine Vorfixierung vorgesehen ist, die die erste elektrische Leitung und die zweite elektrische Leitung zueinander fixiert und die aus einem elektrisch leitenden Kunststoff hergestellt ist.

Durch die in den Unteransprüchen aufgeführten Maßnahmen sind vorteilhafte Weiterbildungen und Verbesserungen des im Hauptanspruch angegebenen piezoelektrischen Aktors möglich.

Besonders vorteilhaft ist, wenn die Vorfixierung stegförmig ausgebildet ist, da auf diese Weise nur wenig Material für die Verbindung der beiden Leitungen notwendig ist.

Weiterhin vorteilhaft ist, wenn die Vorfixierung im Bereich zwischen einem Gehäuse der Vorrichtung und den Steckeranschlüssen angeordnet ist, da auf diese Weise eine höhere Steifigkeit der Leitungen erreicht wird.

Nach einer vorteilhaften Ausgestaltung ist die Vorfixierung auf halber Strecke zwischen dem Gehäuse und den Steckeranschlüssen angeordnet, da auf diese Weise der höchste Widerstand gegen eine Verbiegung erzielt wird.

Sehr vorteilhaft ist es, dass die Vorfixierung Metall- oder Rußpartikel enthält, da die Vorfixierung auf diese Weise eine elektrische Leitfähigkeit erhält.

Gemäß einem vorteilhaften Ausführungsbeispiel weist die Vorfixierung einen ohmschen Widerstandwert im Bereich zwischen 200 Kiloohm und 300 Kiloohm auf.

Des weiteren vorteilhaft ist, wenn die Vorfixierung von einem elektrisch isolierenden Anschlussgehäuse umgeben ist, da auf diese Weise ein Kurzschluss zwischen den Leitungen verhindert wird.

### Zeichnung

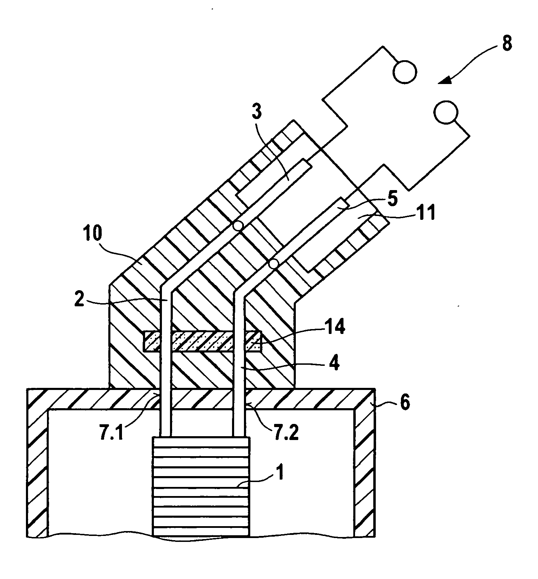

Ein Ausführungsbeispiel der Erfindung ist in der Zeichnung vereinfacht dargestellt und in der nachfolgenden Beschreibung näher erläutert.

### Beschreibung des Ausführungsbeispiels

Die Zeichnung zeigt eine Vorrichtung mit einem piezoelektrischen Aktor.

Die Vorrichtung mit dem piezoelektrischen Aktor ist beispielsweise ein Brennstoffeinspritzventil, kann aber ausdrücklich eine beliebige Vorrichtung mit einem piezoelektrischen Aktor sein.

Die Vorrichtung weist einen Aktor 1 auf, der ein piezoelektrischer oder magnetostriktiver Aktor ist. Der piezoelektrische Aktor 1 besteht aus einer Vielzahl von piezokeramischen Schichten, die durch Anlegen einer elektrischen Spannung eine Dehnung in axialer Richtung ausführen. Dabei wird der sogenannte inverse piezoelektrische Effekt ausgenutzt, bei dem elektrische Energie in mechanische Energie umgewandelt wird. Die durch das Anlegen der elektrischen Spannung erzeugte Dehnung der piezokeramischen Schichten wird beispielsweise bei einem Brennstoffeinspritzventil auf eine Ventilnadel übertragen. Nach Abschalten der elektrischen Spannung verkürzt sich der Aktor 1 wieder.

Der Aktor 1 ist in einem Gehäuse 6 der Vorrichtung angeordnet. Von dem Aktor 1 ausgehend verlaufen eine erste elektrische Leitung 2 durch eine erste Durchführungsöffnung 7.1 im Gehäuse 6 zu einem ersten Steckeranschluss 3 und eine zweite elektrische Leitung 4 durch eine zweite Durchführungsöffnung 7.2 zu einem zweiten Steckeranschluss 5. Der erste Steckeranschluss 3 und der zweite Steckeranschluss 5 sind beispielsweise als sogenannte Steckerfahnen ausgeführt, die mit einem auf den Steckeranschluss 3,5 aufzusteckenden Stecker zur elektrischen Kontaktierung zusammenwirken.

Der Aktor 1 wird über die beiden elektrischen Leitungen 2,4, die beiden Steckeranschlüsse 3,5 und den Stecker mit einer Spannungsquelle 8 elektrisch verbunden.

Die erste Leitung 2 und die zweite Leitung 4 sind beispielsweise von einem Anschlussgehäuse 10 umgeben, das beispielsweise mittels Spritzgusstechnik um die Leitungen 2,4 und zumindest teilweise um die Steckeranschlüsse 3,5 herum gespritzt und aus einem elektrisch isolierenden Kunststoff hergestellt ist. Das Anschlussgehäuse 10 ist beispielsweise an das Gehäuse 6 der Vorrichtung angespritzt. Im Bereich des ersten Steckeranschlusses 3 und des zweiten Steckeranschlusses 5 weist das Anschlussgehäuse 10 eine Aussparung 11 zur Aufnahme des auf die Steckeranschlüsse 3,5 aufzusteckenden Steckers auf. Die Steckerfahnen der Steckeranschlüsse 3,5 reichen von der Aussparung 11 ausgehend bis in das Anschlussgehäuse 10 und sind dort mit den Leitungen 2,4 verbunden, z.B. durch Verschweißen, Verlöten, Verklemmen oder anderes.

Erfindungsgemäß ist zwischen der ersten Leitung 2 und der zweiten Leitung 4 eine beispielsweise stegförmige oder scheibenförmige Vorfixierung 14 vorgesehen, die die Leitungen 2,4 fest miteinander verbindet und auf diese Weise den Abstand zwischen den beiden Leitungen 2,4 festlegt. Die Leitungen 2,4 durchragen die Vorfixierung 14.

Die Vorfixierung 14 wird beispielsweise mittels Spritzgusstechnik gebildet, zeitlich bevor das Anschlussgehäuse 10 hergestellt wird. Auf diese Weise kann sich der Abstand zwischen den Leitungen 2,4 während der Herstellung des Anschlussgehäuses 10 durch Umspritzen der Leitungen 2,4 und der Vorfixierung 14 nicht oder nur geringfügig verändern, so dass ein vorbestimmter Abstand zwischen den Steckeranschlüssen 3,5 erreicht wird.

Die Vorfixierung der ersten Leitung 2 und der zweiten Leitung 4 ist erforderlich, da diese vergleichsweise lang und biegsam ausgebildet sind und bei der Herstellung des Anschlussgehäuses 10 durch Umspritzung der Leitungen 2,4 derart verbogen werden könnten, dass die Steckeranschlüsse 3,5 nach der Herstellung des Anschlussgehäuses 10 nicht maßgerecht angeordnet sein könnten, so dass der Stecker nicht mit den Steckeranschlüssen 3,5 passgerecht verbindbar wäre.

Erfindungsgemäß ist die Vorfixierung 14 aus einem elektrisch leitenden Kunststoff hergestellt und bildet auf diese Weise zugleich einen elektrischen Widerstand, der nicht als elektronisches Bauteil ausgeführt ist, sondern als eine Verbindung zwischen der ersten Leitung 2 und der zweiten Leitung 4 aus elektrisch leitendem Kunststoff. Die Vorfixierung 14 zwischen den Leitungen 2,4 ist im Bereich zwischen dem Gehäuse 6 und den Steckeranschlüssen 3,5 angeordnet, beispielsweise auf halber Strecke zwischen dem Gehäuse 6 und den Steckeranschlüssen 3,5, gemessen entlang oder in Richtung der Leitungen 2,4. Auf diese Weise sind die Leitungen 2,4 deutlich mechanisch stabilisiert und ist der Widerstand gegen eine Verbiegung der Leitungen 2,4 erhöht.

Die als elektrischer Widerstand wirkende Vorfixierung 14 an dem Piezoaktor hat den weiteren Vorteil, dass keine gefährlich hohen Spannungen an dem kapazitiven Piezoaktor außerhalb des Betriebszustandes anliegen können.

Der elektrische Widerstand der Vorfixierung 14 ist einerseits genügend hochohmig ausgeführt, um einen Kurzschluss zwischen der ersten Leitung 2 und der zweiten Leitung 4 zu verhindern und hat andererseits eine ausreichend hohe Leitfähigkeit, um auf dem Piezoaktor 1 gespeicherte elektrische Ladungen abzubauen. Der elektrische Widerstand hat einen ohmschen Widerstandwert von mehreren hundert Kiloohm, beispielsweise im Bereich zwischen 200 Kiloohm und 300 Kiloohm.

Der Umgang mit dem Piezoaktor 1, beispielsweise beim Ein-und/oder Ausbau des Piezoaktors 1 in die Vorrichtung, ist aufgrund der vorgesehenen Ausbildung der Vorfixierung 14 als elektrischer Widerstand gefahrlos. Beim Berühren der Steckeranschlüsse 3,5 kann kein Stromschlag durch restliche auf dem Piezoaktor 1 gespeicherte Ladungen erfolgen.

Die erfindungsgemäß ausgebildete Vorfixierung 14 weist beispielsweise Metall- oder Rußpartikel auf, die im Kunststoff verteilt angeordnet sind. Die Metallpartikel sind beispielsweise faserförmig ausgebildet. Durch die Metall- oder Rußpartikel bilden sich im Kunststoff durchgängige Ketten, die den Kunststoff der Vorfixierung 14 elektrisch leitfähig machen. Der ohmsche Widerstandswert der erfindungsgemäßen Vorfixierung 14 lässt sich durch die Menge der dem Kunststoff beigemischten Metall- oder Rußpartikel einstellen. Je mehr Metallpartikel oder Rußpartikel im Kunststoff der Vorfixierung 14 verteilt sind, desto geringer ist der Widerstand. Da die Anforderungen an die durch die Beimischung von Metall-oder Rußpartikeln eingestellte Genauigkeit des Widerstandswertes vergleichsweise niedrig sind, ist die erfindungsgemäße Ausbildung der Vorfixierung 14 als elektrischer Widerstand sehr kostengünstig.

Da die Funktion des elektrischen Widerstandes in der Vorfixierung 14 integriert ist, kann ein separater elektrischer Widerstand als Elektronikbauteil entfallen, so dass die Kosten für den separaten elektrischen Widerstand und der Arbeitsgang für dessen Einbau eingespart und die Herstellungskosten verringert werden.

## Patentansprüche

1. Vorrichtung mit einem piezoelektrischen Aktor, der eine erste elektrische Leitung, die mit einem ersten Steckeranschluss elektrisch leitend verbunden ist, und eine zweite elektrische Leitung, die mit einem zweiten Steckeranschluss elektrisch leitend verbunden ist, aufweist, **dadurch gekennzeichnet, dass** eine Vorfixierung (14) vorgesehen ist, die die erste elektrische Leitung (2) und die zweite elektrische Leitung (4) zueinander fixiert, und die aus einem elektrisch leitenden Kunststoff hergestellt ist.

2. Vorrichtung nach Anspruch 1, **dadurch gekennzeichnet, dass** die Vorfixierung (14) stegförmig ausgebildet ist.

3. Vorrichtung nach Anspruch 1, **dadurch gekennzeichnet, dass** die Vorfixierung (14) im Bereich zwischen einem Gehäuse (6) der Vorrichtung und den Steckeranschlüssen (3,5) angeordnet ist.

4. Vorrichtung nach Anspruch 3, **dadurch gekennzeichnet, dass** die Vorfixierung (14) auf halber Strecke zwischen dem Gehäuse (6) und den Steckeranschlüssen (3,5) angeordnet ist.

5. Vorrichtung nach Anspruch 1, **dadurch gekennzeichnet, dass** die Vorfixierung (14) Metall- oder Rußpartikel enthält.

6. Vorrichtung nach Anspruch 1, **dadurch gekennzeichnet, dass** die Vorfixierung (14) einen ohmschen Widerstandwert im Bereich zwischen 200 Kiloohm und 300 Kiloohm aufweist.

7. Vorrichtung nach Anspruch 1, **dadurch gekennzeichnet, dass** die Vorfixierung (14) von einem elektrisch isolierenden Anschlussgehäuse (10) umgeben ist.

8. Vorrichtung nach Anspruch 7, **dadurch gekennzeichnet, dass** das Anschlussgehäuse (10) aus Kunststoff hergestellt ist.

9. Vorrichtung nach Anspruch 1, **dadurch gekennzeichnet, dass** die Vorrichtung ein Brennstoffeinspritzventil ist.

## Claims

1. Apparatus having a piezoelectric actuator which has a first electrical line which is electrically conductively connected to a first plug connection, and a second electrical line which is electrically conductively connected to a second plug connection, **characterized in that** a prefixing means (14) is provided which fixes the first electrical line (2) and the second electrical line (4) in relation to one another and which is produced from an electrically conductive plastic.

2. Apparatus according to Claim 1, **characterized in that** the prefixing means (14) is of web-like form.

3. Apparatus according to Claim 1, **characterized in that** the prefixing means (14) is arranged in the region between a housing (6) of the apparatus and the plug connections (3, 5).

4. Apparatus according to Claim 3, **characterized in that** the prefixing means (14) is arranged halfway between the housing (6) and the plug connections (3, 5).

5. Apparatus according to Claim 1, **characterized in that** the prefixing means (4) contains metal or carbon-black particles.

6. Apparatus according to Claim 1, **characterized in that** the prefixing means (14) has a non-reactive resistance in the range of between 200 kilohm and 300 kilohm.

7. Apparatus according to Claim 1, **characterized in that** the prefixing means (14) is surrounded by an electrically insulating connection housing (10).

8. Apparatus according to Claim 7, **characterized in that** the connection housing (10) is produced from plastic.

9. Apparatus according to Claim 1, **characterized in that** the apparatus is a fuel-injection valve.

## Revendications

1. Dispositif comportant un actionneur piézo-électrique dont une première ligne électrique est reliée électriquement à un premier connecteur et une seconde ligne électrique est reliée électriquement à un second connecteur,
**caractérisé par**
une préfixation (14) bloquant l'une par rapport à l'autre la première ligne électrique (2) et la seconde ligne électrique (4) cette fixation étant réalisée en une matière plastique électroconductrice.

2. Dispositif selon la revendication 1,
**caractérisé en ce que**
la préfixation (14) est en forme d'entretoise.

3. Dispositif selon la revendication 1,
**caractérisé en ce que**
la préfixation (14) est prévue dans la zone comprise entre le boîtier (6) du dispositif et les bornes de connecteur (3, 5).

4. Dispositif selon la revendication 3,
**caractérisé en ce que**
la préfixation (14) est installée à mi-chemin entre le boîtier (6) et les bornes de connecteur (3, 5).

5. Dispositif selon la revendication 1,
**caractérisé en ce que**
la préfixation (14) contient des particules de métal ou de noir de fumée.

6. Dispositif selon la revendication 1,
**caractérisé en ce que**
la préfixation (14) a une résistance ohmique comprise entre 200 Kω et 300 Kω.

7. Dispositif selon la revendication 1,
**caractérisé en ce que**
la préfixation (14) est entourée d'un boîtier de raccordement (10) isolant électrique.

8. Dispositif selon la revendication 7,
**caractérisé en ce que**
le boîtier de raccordement (10) est en matière plastique.

9. Dispositif selon la revendication 1,
**caractérisé en ce que**
le dispositif est un injecteur de carburant.
